# EUROPÄISCHE PATENTSCHRIFT

(11) **EP 1 113 992 B1**
(45) Veröffentlichungstag und Bekanntmachung des Hinweises auf die Patenterteilung: **21.06.2006**
(21) Anmeldenummer: 99944597.6
(22) Anmeldetag: 03.09.1999
(51) Int. Cl.: C01G 19/00, H01B 1/08

(54) **VERFAHREN ZUR HERSTELLUNG VON SUSPENSIONEN UND PULVERN AUF BASIS VON INDIUM-ZINN-OXID UND DEREN VERWENDUNG**
METHOD FOR PREPARING SUSPENSIONS AND POWDERS BASED ON INDIUM TIN OXIDE AND THE USE THEREOF
PROCEDE DE PRODUCTION DE SUSPENSIONS ET DE POUDRES A BASE D'OXYDE D'INDIUM ET D'OXYDE D'ETAIN

(30) Priorität: 06.09.1998 DE 19840527; 23.10.1998 DE 19849048
(43) Veröffentlichungstag der Anmeldung: 11.07.2001
(73) Patentinhaber: Leibniz-Institut für Neue Materialien gemeinnützige GmbH, 66123 Saarbrücken (DE)
(72) Erfinder: NONNINGER, Ralph, D-66129 Saarbrücken-Bübingen (DE); GOEBBERT, Christian, D-66111 Saarbrücken (DE); SCHMIDT, Helmut, D-66130 Saarbrücken-Güdingen (DE); DRUMM, Robert, D-66113 Saarbrücken (DE); SEPEUR, Stefan, D-66787 Wadgassen-Schaffhausen (DE)
(74) Vertreter: Barz, Peter
(86) Internationale Anmeldenummer: PCT/EP1999/006498
(87) Internationale Veröffentlichungsnummer: WO 2000/014017

(56) Entgegenhaltungen:
- EP-A- 0 578 584
- US-A- 5 700 419
- GOEBBERT: "transparent conducting coatings made from redispersible crystalline nanoscaled powders" MATERIALS RESEARCH SOCIETY SYMP. PROC., Bd. 574, 1999, Seiten 199-204, XP002126707

## Beschreibung

Die Erfindung betrifft Suspensionen und Pulver auf Basis von Indium-Zinn-Oxid, Verfahren zu deren Herstellung, daraus hergestellte Formkörper sowie Beschichtungs- und Formmassen und deren Verwendung als Beschichtungsmaterialien.

Indium-Zinn-Oxide sind durch ihre optoelektronischen Eigenschaften gekennzeichnet. Sie sind z. B. in Form von dünnen transparenten Schichten in der Lage Infrarotlicht zu reflektieren und zeichnen sich gleichzeitig durch eine relativ hohe elektronische Leitfähigkeit bei vorhandener Transparenz in Schichtsystemen aus. Aus diesem Grunde gibt es sehr viele Anwendungsmöglichkeiten für Indium-Zinn-Oxid (ITO)-Systeme, und dementsprechend auch sehr viele Untersuchungen zu ihrer Herstellung.

Die gängigsten Verfahren zum Auftragen von transparenten Schichten sind Gasphasentechniken, bei denen das ITO aus der Gasphase auf das Substrat in Form einer zusammenhängenden dünnen Schicht abgeschieden wird. Als andere Verfahren werden der Sol-Gel-Prozeß oder Pulver- und Pastentechnologien verwendet.

Das Stoffsystem Indium und Sauerstoff ist durch eine Vielzahl von Verbindungen gekennzeichnet. Die thermodynamisch stabilste ist In₂O₃. Indiumoxide der Zusammensetzung In₄O₃, In₄O₅, In₂O und In₇O₉ werden üblicherweise durch Reduktion von In₂O₃ in Wasserstoffstrom gebildet. In₂O₃ ist bei Zimmertemperatur dunkelgelb bis hellgelb, bei höheren Temperaturen braun bis braunrot und in Mineralsäuren löslich. Röntgenographisch kann nur die kubische Modifikation nachgewiesen werden.

Zur Herstellung reiner Indiumoxidpulver wird in der Literatur überwiegend die Präzipitation aus Lösungen beschrieben. Die gewählten Hydroxide werden danach durch Calcinieren in die Oxide überführt. Wäßrige Salzlösungen werden mit Alkalilösungen, mit Ammoniak oder mit Harnstoff gefällt; siehe z.B. JP 06227815 A2, JP 05193939 A2, JP 04325415 A2, JP 04219315 A2 und DE 2127135 A.

Bisweilen erfolgt die Fällung auch in Gegenwart von Schwefelsäure oder Sulfatlösungen; siehe z.B. JP 05058627 A2. Es finden sich jedoch keine Angaben über den Einfluß des Fällungsmittels auf die Pulverqualität. Auch enthält die Literatur keine oder sehr ungenaue Angaben zu Partikelgröße oder Agglomerationszustand. Die Partikelgrößen, die in der Regel aus den Messungen der BET-Oberfläche der Pulver zurückgerechnet werden, erstrecken sich vom Nanometerbereich bis in den Bereich von 100 µm.

Indiumoxid ist ein wide-gap n-Halbleiter, dessen intrinsische Elektronenleitung auf Sauerstoffehlstellen beruht. Die Mobilität der Ladungsträger wird neben intrakristallinen Effekten vor allem durch die Behinderung interkristalliner Elektronenübergänge beschränkt. Eine Möglichkeit, die geringe Ladungsträgerdichte des reinen Indiumoxids zu erhöhen, ist der gezielte Einbau von vierwertigen Elementen wie z. B. Zinn.

Es sind verschiedene Arten der Herstellung von Indiumoxid-Zinnoxid-Gemischen bekannt. Beim einfachen Mixed-Oxide-Verfahren zur Herstellung von ITO-Gemischen werden Temperaturen zwischen 700°C und 900°C benötigt; siehe z.B. EP 654447 A1. Die Sol-Gel-Technik eignet sich ebenfalls zur Herstellung von ITO-Gemischen, wobei spezifische Pulveroberflächen von 10 m²/g angegeben werden; siehe z.B. JP 06293517 A, JP 06080422 A und JP 05201731 A. Weiter werden Elektrolyseverfahren beschrieben, bei denen durch anodische Oxidation einer Indiumelektrode bzw. einer Indiumzinnelektrode Hydroxide erzeugt werden, die man durch nachfolgendes Calcinieren in Oxide umwandelt; siehe JP 63195101 A2, JP 06171937 A2 und JP 06329415 A2. Es werden auch Indiumzinnhydroxide in organischen Lösungsmitteln dispergiert, durch azeotrope Destillation dehydriert und anschließend durch Trocknen und Calcinierung in die Oxide überführt; siehe JP 02006332 A2. ITO-Pulver lassen sich auch durch eine Lichtbogenentladung zwischen einer Wolframelektrode und einer Indiumelektrode in einem Argon-Sauerstoff-Gemisch (Y. Endo et al., Funtai, Kogaku Kaishi (1995), 32 (12), 874-80) bzw. mittels Aerosolsprühpyrolyse von Indiumacetat in Wasser in einem Argonträgergas (D.M. Speckmann et al., Mater. Res. Soc. Symp. Roc. (1995), 372 (Hollow and Solid Sphere and Microspheres: Science and Technology Associated with Their Fabrication and Application), 247-52 oder durch Versprühen von lndiumzinnsalzlösungen bei 800°C herstellen (JP 01087519 A). Über eine Kondensation von Indiumchlorid und Zinnchlorid aus der Gasphase und nachfolgender Reaktionen mit Sauerstoff oder Wasser läßt sich Indiumoxid oder Zinnoxid ebenso herstellen (JP 05024836 A2) wie durch eine Koronaentladung in reduzierender Atmosphäre bei 1000°C (DE 4407774 C1).

Zur Herstellung von ITO-Schichten werden z.B. direkt ITO-Pulver eingesetzt. So verwenden z.B. die JP 07118840 A ein ITO-Pulver mit einer spezifischen Oberfläche von 30 m²/g, die JP 06049394 A ein ITO-Pulver mit einem Durchmesser von 200 nm und die JP 05036314 A ein ITO-Pulver mit einer mittleren Partikelgröße von 30 nm.

Zusammenfassend bedeutet dies, daß eine Vielzahl an Herstellungsverfahren für zinndotierte Indiumoxid (ITO)-Pulver vorliegen. Definierte Angaben über Pulverqualitäten in Verbindung mit ihrer Herstellungsweise sind jedoch nicht beschrieben. Die Qualität der eingesetzten Pulver wird üblicherweise über die Anwendung definiert In den letzten Jahren hat das Interesse an einer definierten Herstellung und Anwendung transparenter leitfähiger Schichten auf verschiedenen Substraten stark an Bedeutung gewonnen. Während die Anwendung Sb- und F-dotierter Zinnoxidschichten auf Glassubstraten aufgrund ihrer Leitfähigkeit, ihrer Transparenz im sichtbaren Spektralbereich und ihrer Reflekdonseigenschaften im IR-Bereich für die Oberflächenbeheizung von Gläsern für Flugzeuge, Raumschiffe, Kameras und auch für elektrostatische Abschirmzwecke schon lange bekannt ist, sind in neuerer Zeit vielfältige Anforderungen an derartige Schichten für die Anwendungen in der Mikro- und Optoelektonik entstanden. Dazu gehören z. B.
1. transparente Ansteuerelektroden für Flüssigkristalldisplays, Dünnfilmelektrolumineszenz-Displays und Elektrochromie-Displays
2. transparente leitfähige Schichten für hochempfindliche Strahlungsdetektoren, ferroelektrische Photoleiter und Speicheranordnungen
3. transparente leitfähige Oxidfilme als Gate-Elektroden für Ladungs-, Injektions- und ladungsgekoppelte Anordnungen.

Diese Anwendungen in der Optoelektronik sind gleichfalls mit höheren Anforderungen an die Leitfähigkeit, Transparenz und Strukturierbarkeit der Schichten verbunden. Aufgrund der ungünstigen Strukturierungseigenschaften dotierter Zinnoxidschichten bei der üblichen Strukturierung durch chemische Ätztechnologien haben sich für diese Anwendungen überwiegend zinndotierte Indiumoxidschichten (ITO) durchgesetzt.

Weiterhin zeigen diese ITO-Schichten im Vergleich zu dotierten Zinnoxidschichten eine wesentlich bessere Leitfähigkeit und Transparenz. Zinndotierte Indiumoxidschichten stellen zur Zeit die leitfähigsten Beschichtungen dar, die kommerziell erhältlich sind. Im Routinebetrieb liegt der erreichbare spezifische Widerstand bei etwa 1 - 2 x 10⁻⁴ Ohm.cm, was in Verbindung mit einer etwa 30 nm dicken Sperrschicht aus SiO₂ bereits bei 120 nm Schichtdicke zu einem Flächenwiderstand von 15 Ω/□ führt. (Transparenz > 90%). Bedingt durch die Herstellung im Sputter- bzw. CVD-Verfahren sind die Kosten für diese Art der Beschichtung vergleichsweise hoch und großflächige Beschichtungen sind nur schwer durchzuführen.

Die hohe Ladungsträgerdichte in Verbindung mit einer Ladungsträgermobilität im Bereich von 40 - 60 cm²/Vs führt zu einer sehr hohen Transparenz im sichtbaren Bereich, bei gleichzeitig hervorragender Reflexion im IR-Bereich. Der Anteil an Zinnoxid liegt üblicherweise zwischen 7-12 Gew.%.

Für viele Anwendungsgebiete, insbesondere in der Mikro- und Optoelektronik, bei optischen und IR blockierenden Beschichtungen ist es wichtig, daß ITO-Pulver verwendet werden, die aus nanoskaligen Partikeln bestehen. Solche nanoskaligen Partikel weisen eine durchschnittliche Teilchengröße von bevorzugt nicht mehr als 200 nm, insbesondere nicht mehr als 50 nm und besonders bevorzugt nicht mehr als 30 nm auf. Ein besonders bevorzugter Bereich liegt bei 5 bis 30 nm.

Bei vielen Verfahren zur Herstellung von Indium-Zinn-Oxid-Pulvern oder -Suspensionen werden Suspensionen von Vorstufen des Indium-Zinn-Oxid-Pulvers erhalten, aus denen nach Trocknung die Indium-Zinn-Oxid-Pulver durch Calcinierung hergestellt werden. Die Partikelgrößen der so hergestellten Pulvern liegen aber nicht im gewünschten nm-Bereich und die Pulver können auch nicht wieder zu Suspensionen mit Partikelgrößen im nm-Bereich (nanoskalige Partikel) aufgearbeitet werden, so daß mit derart hergestellten dünnflüssigen Suspensionen keine Beschichtungen über Tauch-, Sprüh- oder ähnliche Verfahren mit Partikelgrößen im nm-Bereich hergestellt werden können.

Zwar entstehen bei der Bildung der ITO-Pulvervorstufen in Suspension unter den geeigneten Bedingungen nanoskalige Primärpartikel geeigneter Größe, bei der Aufarbeitung, insbesondere bei der Calcinierung, aggregieren diese Primärpartikel aber zu größeren Partikeln. Diese Aggregatbildung ist darauf zurückzuführen, daß mit abnehmender Partikelgröße auch schwache Wechselwirkungskräfte, wie z.B. van der Waals-Kräfte, erheblich an Bedeutung gewinnen bzw dominieren. Hinzu kommt, daß die Partikeloberfläche immer mit funktionellen, d.h. kondensationsfähigen, Gruppen belegt ist, die durch Kondensationsreaktionen zwischen einzelnen Primärpartikeln zur Bildung harter Aggregate führen. Die Primärpartikel sind dann quasi über Sinterhälse miteinander verbunden. Diese aus Primärpartikeln bestehenden Aggregate können durch einen einfachen Dispergierungsschritt in einem nichtwäßrigen oder wäßrigen Lösungsmittel nicht mehr aufgebrochen werden.

Derartige über eine Calcinierung hergestellte Pulver können nicht für hochtransparente Schichten verwendet werden, da Partikel mit Größen über 50 nm schon zu optischen Störungen führen.

In der EP-A-578 584 wird ein Verfahren zur Herstellung eines leitfähigen Metalloxid-Pulvers, bei dem es sich um Indiumzinnoxid handeln kann, beschrieben, in welchem eine kolloidale wäßrige Lösung kristalliner Teilchen aus mindestens einem Metalloxid oder einem Metallmischoxid durch Hydrolyse einer Ausgangslösung mit Metallionen und Komplexbildnern gebildet wird und die Teilchen unter Entfernung restlicher Salze und Komplexbildner wärmebehandelt werden.

US-A-5 700 419 offenbart ein Verfahren zur Herstellung eines gesinterten ITO-Produkts, bei dem eine wäßrige Aufschlämmung, umfassend Indiumoxid, Zinnoxid, Bindemittel, Dispergiermittel und ein wäßriges Medium, in eine Form unter Bildung eines Grünkörpers gegossen wird und der erhaltene Grünkörper gesintert wird.

Aufgabe der vorliegenden Erfindung war es Zusammensetzungen auf der Basis von Indium-Zinn-Oxid so herzustellen, daß trotz Calcinierung nanoskalige Partikel mit geeigneter Größe erhalten werden und die Pulver in einem einfachen Dispergierungsschritt zu Suspensionen verarbeitet werden können, wobei die Primärpartikelgröße vollständig erhalten bleibt.

Dies gelingt erfindungsgemäß durch ein Verfahren zur Herstellung von Suspensionen und Pulvern auf Basis von Indium-Zinn-Oxid, das dadurch gekennzeichnet ist, daß man
a) Indium-Zinn-Oxid-Vorstufen aus Lösungen von Indium- und Zinn-Verbindungen in einem oder mehreren Lösungsmitteln in Gegenwart einer oder mehrerer oberflächenmodifizierender Komponenten ausfällt,
b) das erhaltene Pulver nach Entfernung des Lösungsmittels calciniert,
c) nach dem Calcinieren eine oder mehrere oberflächenmodifizierende Komponenten und ein oder mehrere Lösungsmittel zugibt,
d) die erhaltene Mischung einer Zerkleinerungs- oder Dispergierbehandlung uner Bildung einer Suspension unterwirft und
e) gegebenenfalls flüssige Komponenten aus der Suspension abtrennt, um ein Pulver zu erhalten, dadurch gekennzeichnet, dass als oberflächenmodifizierende Komponente bei der Zerkleinerung oder Dispergierung Mono- oder Polycarbonsäuren, Diketone, Aminosäuren, Polyethylenoxidderivate, Amine oder Säureamide oder Mischungen aus zwei der mehreren dieser Komponenten eingesekt werden.

Ferner können gegebe enfalls die Suspension oder das daraus hergestellte Pulver über ein Formgebungsverfahren in einen Formkörper überführt werden.

In dem erfindungsgemäßen Verfahren werden überraschenderweise Suspensionen und Pulver auf Basis von Indium-Zinn-Oxid erhalten, die im wesentlichen aus Primärpartikeln bestehen und im wesentlichen keine durch Aggregation von Primärpartikeln gebildete Agglomerate enthalten. Die Pulver lassen sich leicht zu Suspensionen redispergieren, in denen die Primärpartikelgröße praktisch vollständig erhalten bleibt.

Unter einem Indium-Zinn-Oxid-Pulver, das auch als ITO-Pulver bezeichnet wird, wird ein Pulver verstanden, das im wesentlichen aus einem Mischoxid von Indium und Zinn besteht. Das Indium und das Zinn können darin in einer oder in verschiedenen Oxidationsstufen vorliegen. Beispielsweise liegen In(+I) und/oder In(+III) sowie Sn(+II) und/oder Sn(+IV) vor. Sn liegt bevorzugt als Sn(+IV) vor. Gegebenenfalls können Indium und Zinn auch teilweise als In(0) oder Sn(0) vorliegen. Auf der Oberfläche der Partikel des ITO-Pulvers sind auch die nachstehend beschriebenen oberflächenmodifizierenden Komponenten vorhanden.

Bevorzugt handelt es sich bei dem ITO-Pulver um ein zinndotiertes Indiumoxid, d.h. der Anteil an Zinnoxid ist geringer als der Anteil an Indiumoxid. Der Anteil an Zinnoxid bezogen auf das Indium-Zinn-Oxid, ohne Berücksichtigung der oberflächenmodifizierenden Komponente, beträgt beispielsweise 2 bis 30 Mol-%, bevorzugt 7 bis 12 Mol-%. Das ITO-Pulver kann beispielsweise, ohne Berücksichtigung der oberflächenmodifizierenden Komponente, durch die Formel In_{2-y}Sn_{y}O₃ mit 0 ≤ y < 2, insbesondere 0 ≤ y < 1 ausgedrückt werden (Ladungsüberschuß: e⁻_{y}).

Selbstverständlich kann das Indium-Zinn-Oxid-Pulver Verunreinigungen enthalten. Der akzeptierbare Grad hängt vom Verwendungszweck ab. Über die Edukte kann z. B. SO₄²⁻, Ca, Co, Cu, Fe, Ni, Pb, Zn, K oder Na enthalten sein. Durch Verwendung reiner Edukte können SO₄²⁻, Ca, Co, Cu, Fe, Ni, Pb und Zn auf unter 0,005 Gew.-% und Na, K auf unter 0,01 Gew.% gebracht werden. Über das Verfahren kann z. B. NH₄⁺ und Cl⁻ in das Produkt gelangen, das je nach Anzahl der Waschcyclen praktisch gänzlich entfernt werden kann. Bezogen auf das Indium-Zinn-Oxid-Pulver sind aber unter Berücksichtigung der oberflächenmodifizierenden Komponente weniger als 5 Gew.-%, bevorzugt weniger als 1 Gew.-%, insbesondere bevorzugt weniger als 0,1 Gew.-% Verunreinigungen enthalten.

In dem erfindungsgemäßen Verfahren werden aus Lösungen von Indium- und Zinn-Verbindungen Indium-Zinn-Oxid-Vorstufen in Gegenwart einer oder mehrerer oberflächenmodifizierender Komponenten aus einem oder mehreren Lösungsmitteln ausgefällt.

Bei dem Fällungsprozeß bzw. dem Co-Fällungsprozeß kann es sich um jedes hierfür nach dem Stand der Technik bekannte Verfahren handeln. Die Fällung kann beispielsweise über ein Sol-Gel-Verfahren, ein Elektrolyseverfahren, ein Dehydratisierungsverfahren oder ein Aerosalsprühpyrolyseverfahren, wie sie vorstehend beschrieben wurden, durchgeführt werden. Bevorzugt erfolgt die Fällung aber durch ein Sol-Gel-Verfahren. Bei dem Sol-Gel-Verfahren werden bei Anwesenheit von Wasser z.B. durch Zusatz von Basen oder Säuren Hydrolyse- und Kondensationsreaktionen eingeleitet, die zur Fällung von Hydroxo(Oxo)-kondensaten führen. Dabei werden zur Fällung der Indium-Zinn-Oxid-Vorstufen besonders bevorzugt Basen, insbesondere primäre, sekundäre, tertiäre aliphatische oder aromatische Amine, Tetramethylammoniumhydroxid, NaOH, KOH, Ammoniak, Ammoniumhydroxid oder Mischungen davon eingesetzt. Besonders bevorzugt wird **Ammoniumhydroxid für die Fällung eingesetzt.**

Als Indium- und Zinn-Verbindungen können alle Indium- bzw. Zinn-Verbindungen eingesetzt werden, aus denen durch Fällung und gegebenenfalls anschließender Nachbearbeitung, wie beispielsweise einer Calcinierung, Indium-Zinn-Oxid-Pulver erhalten werden können. Naturgemäß richtet sich die Wahl der Indium- und Zinn-Verbindungen nach dem eingesetzten Fällungsverfahren. Beispielsweise können bei Elektrolyseverfahren Indiumelektroden oder Indiumzinnelektroden und bei Dehydratisierungsverfahren Indiumzinnhydroxide als Indium- und Zinn-Verbindungen dienen.

Bevorzugte Indium- und Zinn-Verbindungen sind, insbesondere bei Sol-Gel-Fällungsverfahren, Indiumchlorid, Indiumiodid, Indiumnitrat, Indiumacetat, Indiumsulfat, Indiurnalkoxide; wie Indiummethoxid oder Indiumethoxid, oder Mischungen davon bzw. Zinnchlorid, Zinnsulfat, Zinnalkoxide, wie Zinnmethoxid oder Zinnethoxid, oder Mischungen davon, wobei Zinn in der Oxidationsstufe +2 oder +4 und Indium in der Oxidationsstufe +3 oder beim Chlorid und lodid auch in der Oxidationsstufe +1 vorliegt.

Bei den Indium-Zinn-Oxid-Vorstufen handelt es sich im wesentlichen um Hydroxy(oxy)-Kondensate von Indium und Zinn.

Die Indium- und Zinn-Verbindungen werden gemeinsam aus einem oder mehreren Lösungsmitteln gefällt. Die Indium- und Zinn-Verbindungen sind bevorzugt vollständig in dem oder den Lösungsmittel(n) gelöst. Als Lösungsmittel werden vorzugsweise Wasser und/oder organische Lösungsmittel eingesetzt. Ein besonders bevorzugtes Lösungsmittel ist destilliertes (reines) Wasser. Als organische Lösungsmittel eignen sich sowohl polare als auch unpolare und aprotische Lösungsmittel. Beispiele hierfür sind Alkohole, wie z.B. aliphatische Alkohole mit 1 bis 6 Kohlenstoffatomen (insbesondere Methanol, Ethanol, n- und i-Propanol und Butanol); Ketone, wie z.B. Aceton und Butanon; Ester, wie z.B. Essigsäureethylester; Ether, wie z.B. Diethylether, Tetrahydrofuran und Tetrahydropyran; Amide, wie z.B. Dimethylacetamid und Dimethylformamid; Sulfoxide und Sulfone, wie z.B. Sulfolan und Dimethylsulfoxid; und aliphatische (gegebenenfalls halogenierte) Kohlenwasserstoffe, wie z.B. Pentan, Hexan und Cyclohexan. Selbstverständlich können auch Mischungen derartiger Lösungsmittel eingesetzt werden.

Das eingesetzte Lösungsmittel hat vorzugsweise einen Siedepunkt, der eine problemlose Entfernung desselben durch Destillation (gegebenenfalls unter Vakuum) ermöglicht. Bevorzugt werden Lösungsmittel mit einem Siedepunkt unter 200°C, insbesondere unter 150°C.

Die Fällung findet in Gegenwart von oberflächenmodifizierenden Komponenten statt. Bei der oder den oberflächenmodifizierenden Komponente(n) kann es sich beispielsweise um kurzkettige organische Moleküle handeln. Derartige Verbindungen weisen vorzugsweise nicht mehr als insgesamt 24, insbesondere nicht mehr als insgesamt 18 und besonders bevorzugt nicht mehr als 12 Kohlenstoffatome auf. Die Anlagerung an die Oberfläche der entstehenden Primärpartikel kann beispielsweise über eine kovalente oder ionische Bindung und/oder polare (Dipol-Dipol-Wechselwirkung) oder van-der-Waals-Kräfte erfolgen. Bevorzugt weisen die oberflächenmodifizierenden Komponenten eine oder mehrere funktionelle Gruppen auf. Die funktionellen Gruppen, die diese Verbindungen tragen, richten sich in erster Linie nach den Oberflächengruppen des resultierenden ITO-Pulvers und darüber hinaus auch nach der gewünschten Wechselwirkung. Beispiele für bevorzugte funktionelle Gruppen sind Carbonsäuregruppen, Säureamidgruppen (primäre, sekundäre und tertiäre) Aminogruppen, Hydroxylgruppen und C-H-acide Gruppierungen, wie in β-Dicarbonylverbindungen. Es können auch mehrere dieser Gruppen gleichzeitig in einem Molekül vorhanden sein (Betaine, Aminosäuren, EDTA, usw.).

Demgemäß sind Beispiele für die oberflächenmodifizierenden Komponenten gesättigte oder ungesättigte Mono- und Polycarbonsäuren (vorzugsweise Monocarbonsäuren) mit 1 bis 24 Kohlenstoffatomen.

Beispiele für weitere geeignete oberflächenmodifizierenden Komponenten sind Mono- und Polyamine, insbesondere solche der allgemeinen Formel R₃₋ₙNHₙ, worin n = 0, 1 oder 2 und die Reste R unabhängig voneinander Alkylgruppen mit 1 bis 12, insbesondere 1 bis 6 und besonders bevorzugt 1 bis 4 Kohlenstoffatomen darstellen (z.B. Methyl, Ethyl, n- und i-Propyl und Butyl) und Polyethylenamine; β-Dicarbonylverbindungen mit 4 bis 12, insbesondere 5 bis 8 Kohlenstoffatomen; Organoalkoxysilane, wie z.B. diejenigen, die zur Oberflächenmodifizierung von kolloidaler Kieselsäure eingesetzt werden (z.B. solche der allgemeinen Formel R₄₋ₘSi(OR')ₘ worin die Gruppen R und R' unabhängig voneinander C₁-C₄-Alkyl darstellen und m 1, 2, 3 oder 4 ist); und modifizierte Alkoholate, bei denen ein Teil der OR-Gruppen (R wie oben definiert) durch inerte organische Gruppen substituiert ist und über die noch vorhandenen OR-Gruppen eine Anbindung (Kondensation) auf der Partikeloberfläche erfolgt und die organischen Gruppen die Abschirmung übernehmen. Beispiele hierfür sind z.B. Zirkon-und Titanalkoholate M(OR)₄ (M = Ti, Zr), bei denen ein Teil der OR-Gruppen durch einen Komplexbildner, wie z.B. eine β-Dicarbonylverbindung oder eine (Mono)carbonsäure ersetzt ist.

Eine weitere Gruppe von verwendbaren oberflächenmodifizierenden Komponenten sind Tenside, z.B. kationische, anionische, nicht-ionische und amphotere Tenside. Bevorzugt werden nicht-ionische Tenside, wobei Polyethylenoxid-Derivate besonders bevorzugt sind. Es kann sich dabei z. B. um Derivate mit gesättigten oder ungesättigten (Mono)carbonsäuren handeln, insbesondere mit Carbonsäuren mit mehr als 7, bevorzugt mehr als 11 Kohlenstoffatomen, z. B. Polyethylenoxid-Derivate mit Stearin-, Palmitin- oder Ölsäure, etwa die unter der Marke "Emulsogen" erhältlichen Produkte. Es kann sich auch um Derivate mit Sorbitanestern (Sorbitan + Carbonsäure) handeln, wobei als Carbonsäure beispielsweise die vorstehend genannten in Frage kommen. Diese Produkte sind im Handel unter der Marke "Tween" erhältlich. Weiter können Polyethylenoxid(mono)alkylether, beispielsweise mit Alkoholen mit mehr als 7, bevorzugt mehr als 11 Kohlenstoffatomen verwendet werden, z. B. die unter der Marke **"Brij" erhältlichen Produkte.**

Konkrete Beispiele für einsetzbare oberflächenmodifizierende Komponenten sind
a. Mono- und Polycarbonsäuren wie Ameisensäure, Essigsäure, Propionsäure, Buttersäure, Pentansäure, Hexansäure, Acrylsäure, Methacrylsäure, Crotonsäure, Citronensäure, Adipinsäure, Bernsteinsäure, Glutarsäure, Oxalsäure, Maleinsäure, Fumarsäure, Itaconsäure, Stearinsäure und insbesondere 3,6,9-Trioxadecansäure sowie die entsprechenden Anhydride,
b. Diketone wie Acetylaceton, 2,4-Hexandion, 3,5-Heptandion, Acetessigsäure, Acetessigsäure-C₁-C₄-Alkyl-ester wie Acetessigsäureethylester, Diacetyl und Acetonylaceton,
c. Aminosäuren, insbesondere β-Alanin, aber auch Glycin, Valin, Aminocapronsäure, Leucin und Isoleucin,
d. Polyethylenoxid-Derivate, insbesondere Tween® 80 (Sorbitan-monooleatpolyoxyalkylen), aber auch Emulsogen® (Hexaglycolmonostearat), Emulsogen® OG (Ölsäurederivat) und Brij ® 30 (Polyoxyethylenlaurylether),
e. Säureamide, insbesondere Caprolactam, und
f. Amine wie z.B. Methylamin, Dimethylamin. Trimethylamin, Anilin, N-Methylanilin, Diphenylamin, Triphenylamin, Toluidin, Ethylendiamin, Diethylentriamin.

Diese oberflächenmodifizierenden Komponenten können einzeln oder als Mischung eingesetzt werden. Besonders bevorzugte Verbindungen sind 3,6,9-Trioxadecansäure, β-Alanin, Tween® 80 und Caprolactam.

Der Anteil der oberflächenmodifizierenden Komponente(n), bezogen auf das ITO-Pulver, liegt bevorzugt zwischen 2 und 30 Gew.-%, besonders bevorzugt zwischen 2 und 6 Gew.-%.

Die Fällung in Gegenwart der oberflächenmodifizierenden Komponente(n) erfolgt bevorzugt bei einer Temperatur von Raumtemperatur (20°C) bis zur Siedetemperatur des Lösungsmittels. Besonders bevorzugt sind Temperaturen im Bereich von 20 bis 100°C. Die oberflächenmodifizierenden Komponenten sind üblicherweise teilweise oder vollständig auf der Oberfläche der entstehenden Indium-Zinn-Oxid-Pulverpartikel angelagert. Ohne an eine Theorie gebunden zu sein, wird davon ausgegangen, daß die oberflächenmodifizierenden Komponenten nach Entfernung des Lösungsmittel und der Calcinierung zumindest teilweise auf der Oberfläche der Pulverpartikel verbleiben können. Es ist aber auch möglich, daß die oberflächenmodifizierenden Komponenten im Endprodukt nicht mehr vorhanden sind.

Anschließend wird das Lösungsmittel beispielsweise durch Filtrieren, Verdampfen und/oder Zentrifugieren und gegebenenfalls Trocknen, beispielsweise unter Vakuum und/oder erhöhter Temperatur (z.B. bei Temperaturen bis zu 250°C oder bis zu 200°C) oder durch Gefriertrocknen entfernt. Bei dem so erhaltenen Pulver handelt es sich üblicherweise um Partikel aus einem Indium-Zinn-Oxid/Hydroxid-Gemisch, wobei die Partikel gegebenenfalls an der Oberfläche modifiziert sind.

Das erhaltene Pulver wird dann calciniert. Bevorzugt wird dies in einem Ofen ausgeführt. Die Calcinierung erfolgt beispielsweise bei Temperaturen zwischen 200 und 400°C, bevorzugt zwischen 230 und 280°C, besonders bevorzugt 250°C. Die isotherme Haltezeit beträgt beispielsweise zwischen 15 und 120 min, bevorzugt zwischen 45 und 90 min, besonders bevorzugt 60 min.

Die Calcinierung erfolgt bevorzugt unter reduzierenden Bedingungen, wobei ebenfalls die vorstehend genannten Verfahrensbedingungen zur Anwendung kommen. Die reduzierenden Bedingungen werden bevorzugt durch Durchleiten eines reduzierenden Gases/Gasgemisches oder eines reduzierenden Dampfes erhalten. Vor Einsatz der reduzierenden Komponente kann der Ofen mit einem Inertgas, z. B. Stickstoff gespült werden. Als reduzierendes Gas/Gasgemisch oder reduzierender Dampf kann beispielsweise Kohlenmonoxid, Kohlenmonoxid/Stickstoff, eine Wasserdampf-Atmosphäre oder Formiergas (Wasserstoff/Stickstoff) verwendet werden. Dabei ist die Verwendung von Formiergas besonders bevorzugt. Der eingesetzte Gasfluß hängt von der Menge des zu calcinierenden Pulvers und der reduzierenden Komponente ab.

Sofern das Pulver nicht unter reduzierenden Bedingungen calciniert wurde, kann die Reduktion auch nach der Calcinierung durchgeführt werden, beispielsweise durch Sinterung des Pulvers oder Formkörpers unter reduzierenden Bedingungen. Zur Reduktion können dann ebenfalls die vorstehend genannten Gase/Gasgemische oder Dämpfe eingesetzt werden.

Das calcinierte, gegebenenfalls reduzierte Pulver ist in dieser Form trotz des Einsatzes von oberflächenmodifizierenden Komponenten durch einfache Dispergierung nur noch unvollständig in eine Suspension mit Primärpartikelgröße, die üblicherweise im unteren nm-Bereich liegt, zu überführen.

Erfindungsgemäß wird das calcinierte Pulver einer Zerkleinerungs- oder Dispergierungsbehandlung unter Zugabe weiterer oberflächenmodifizierender Komponenten und eines oder mehrerer Lösungsmittel unterworfen. Die Zerkleinerungs- oder Dispergierungsbehandlung kann auf jede denkbare Weise erfolgen; bevorzugt handelt es sich um eine Zerkleinerungsbehandlung. Besonders bevorzugt ist die mechanische Zerkleinerungsbehandlung und/oder die Zerkleinerungsbehandlung mittels Ultraschall.

Der mechanische Zerkleinerungsschritt kann z. B. in Mühlen, Knetern oder Walzenstühlen durchgeführt werden. Geeignete Vorrichtungen für die mechanische Zerkleinerung sind beispielsweise Planetkugelmühlen, Rührwerkskugelmühlen und insbesondere Scherwalzenkneter, Mörsermühlen und Dreiwalzenstühle. Die Zerkleinerung, die z. B. aus Mahlen und Homogenisieren bestehen kann, wird bevorzugt bei Raumtemperatur ausgeführt. Die Dauer hängt von der Art der Mischung und der verwendeten Zerkleinerungsvorrichtung ab.

Die Zerkleinerung oder Dispergierung erfolgt unter Zusatz von einer oder mehreren oberflächenmodifizierenden Komponenten. Prinzipiell handelt es sich dabei um dieselben Verbindungen, die bereits vorstehend als oberflächenmodifizierende Komponenten für den Einsatz bei der Fällung beschrieben wurden. Dabei können in dieser Stufe dieselben Verbindungen als oberflächenmodifizierende Komponenten eingesetzt werden, die bei der Fällung verwendet wurden. Alternativ können aber auch bei der Fällung und bei der Zerkleinerung unterschiedliche oberflächenmodifizierende Komponenten verwendet werden.

Organische Carbonsäuren und ihre Derivate, wie Anhydride und Säureamide, werden bevorzugt als oberflächenmodifizierende Komponente bei der Zerkleinerung oder Dispergierung eingesetzt. Es wird auf die vorstehend aufgeführten Beispiele verwiesen. Besonders bevorzugt ist der Einsatz von 3,6,9-Trioxadecansäure.

Bei der Zerkleinerung oder Dispergierung wird die oberflächenmodifizierende Komponente, bezogen auf das eingesetzte Indium-Zinn-Oxid-Pulver, bevorzugt in einer Menge von 2 bis 30 Gew.-%, besonders bevorzugt von 2 bis 10 Gew.-%, zugegeben.

Die Zerkleinerung oder Dispergierung wird bevorzugt unter Zusatz von einem oder mehreren Lösungsmitteln durchgeführt. Als Lösungsmittel können die Lösungsmittel verwendet werden, die vorstehend für den Fällungsschritt beschrieben wurden. Bevorzugt werden als Lösungsmittel aber hochsiedende Flüssigkeiten verwendet. Unter hochsiedenden Flüssigkeiten werden dabei z. B. Flüssigkeiten mit einem Siedepunkt über 120°C, bevorzugt über 150°C verstanden. Bevorzugt werden hochsiedende Glycole oder Glycolether eingesetzt, beispielsweise Ethylen-, Propylen- oder Butylenglycol oder die entsprechenden Di-, Tri-, Tetra-, Penta- oder Hexamere, sowie die entsprechenden Mono- oder Diether, wobei eine oder beide Hydroxygruppen durch z.B. eine Methoxy, Ethoxy, Propoxy oder Butoxygruppe ersetzt sind. Weitere Beispiele sind Terpene, z.B. Terpineol; Polyole, z.B. 2-Methyl-2,4-pentandiol; und Polyethylenglycole und deren Ether, wie Diethylenglycol, Triethylenglycol, Tetraethylenglycol, Diethylenglycoldiethylether, Tetraethylenglycoldimethylether oder Diethylenglycolmonobutylether. Ethylenglycol, Diethylenglycol und Diethylenglycolmonobutylether werden bevorzugt eingesetzt. Selbstverständlich können auch Mischungen aus zwei oder mehreren dieser Lösungsmittel eingesetzt werden, beispielsweise im Volumenverhältnis von 2:1 bis 1:2.

Das Lösungsmittel kann bei der Zerkleinerung oder Dispergierung, bezogen auf das eingesetzte Indium-Zinn-Oxid-Pulver, in einer Menge von 5 bis 150 Gew.-%, bevorzugt von 10 bis 100 Gew.-%, besonders bevorzugt von 30 bis 50 Gew.-% zugegeben werden. Eine besonders bevorzugtes Verhältnis von Pulver zu Lösungsmittel ist 75:25. Bevorzugt wird die Menge des Lösungsmittels so gewählt, daß pastöse bzw. hochviskose Suspensionen erhalten werden.

Die so erhaltene ITO-Suspension kann direkt, beispielsweise für Beschichtungszwecke verwendet werden. Gegebenenfalls kann vorher noch zur Erhöhung der Viskosität weiteres Lösungsmittel (entweder das bereits eingesetzte oder ein anderes der vorstehend beschriebenen Lösungsmittel) zugefügt werden.

Zu der ITO-Suspension können Bindemittel zugesetzt werden. Die entstehenden Beschichtungs- oder Formmassen können ebenfalls als Beschichtungsmaterial und/oder als Formkörper verwendet werden. Die Bindemittel können in solchen Mengen zugegeben werden, daß sich z.B. ein ITO-Füllgrad der Schicht von 1 bis 95 Vol.-%, bevorzugt 5 bis 80 Vol.-%, ergibt. Unter ITO-Füllgrad wird dabei die Menge an Indium-Zinn-Oxid bzw. Indium-Zinn-Oxid-Pulver in Vol.-% bezogen auf den Gesamtfeststoffgehalt der nach Auftragung auf ein Substrat und Trocknung erhaltenen Schicht verstanden.

Als Bindemittel können prinzipiell alle dem Fachmann bekannten anorganischen, organisch modifizierten anorganischen oder organischen Bindemittel oder Mischungen davon eingesetzt werden. Beispiele für organische Bindemittel sind Polyvinylharze wie Polyolefine, PVC, Polyvinylalkohol, Polyvinylester oder Polystyrol, Acrylharze wie Acrylester oder Methacrylester, Alkydharze, PolyurethanLacke, Harnstoff-, Melamin-, Phenolharz-Lacke oder Celluloseester, wie Ester der Cellulose mit Essigsäure oder Buttersäure.

Bevorzugt handelt es sich bei den Bindemitteln um anorganische oder organisch modifizierte anorganische Bindemittel. Beispiele für organisch modifizierte anorganische Bindemittel sind Polyorganosiloxane bzw. Silicon-Lacke. Die Polyorganosiloxane bzw. die Silicon-Lacke werden bevorzugt nach dem Sol-Gel-Verfahren hergestellt (Sol-Gel-Lack). Zur Herstellung werden bevorzugt hydrolysierbare Silane verwendet. Die hydrolysierbaren Silane können bevorzugt nicht hydrolysierbare Substituenten aufweisen.

Bei den hydrolysierbaren Silanen handelt es sich bevorzugt um Silane der allgemeinen Formel RₙSiX₄₋ₙ. Bei der oder den Gruppen X, die gleich oder verschieden sein können, und vorzugsweise identisch sind, handelt es sich um hydrolysierbare Reste. Die Reste X werden vorzugsweise aus Halogenatomen (insbesondere Chlor und Brom), Alkoxygruppen, Alkylcarbonylgruppen und Acyloxygruppen ausgewählt, wobei Alkoxygruppen, insbesondere C₁₋₄-Alkoxygruppen wie Methoxy und Ethoxy besonders bevorzugt sind. n kann die Werte 1, 2 oder 3, vorzugsweise 1 oder 2 und besonders bevorzugt 1, annehmen. Die eingesetzten hydrolysierbaren Silane können auch vollständig hydrolysierbare Silane der obigen Formel, in der n gleich 0 ist, umfassen, vorzugsweise in einem Anteil von weniger als 50 Mol-% auf Basis aller eingesetzten monomeren hydrolysierbaren Silane.

Die Gruppe R oder die Gruppen R, die gleich oder verschieden sein können, können Alkyl, Alkenyl, Aryl, Alkylaryl, Arylalkyl oder R'Y sein. R' ist geradkettiges oder verzweigtes Alkylen, das durch Sauerstoff- oder Schwefelatome oder NH-Gruppen unterbrochen sein kann, Phenylen, Alkylphenylen oder Alkylenphenylen. Y ist die funktionelle Gruppe, über die eine Vernetzung möglich ist. Beispiele für Y sind gegebenenfalls substituierte Amino-, Amid-, Alkylcarbonyl, gegebenenfalls substituierte Anilino-, Aldehyd-, Keto-, Carboxyl-, Hydroxyl-, Alkoxy-, Alkoxycarbonyl, Mercapto-, Cyano-, Hydroxyphenyl-, Carbonsäurealkylester-, Sulfonsäure-, Phosphorsäure-, Acryloxy-, Methacryloxy-, Methacryloxy-, Glycidyloxy-, Epoxid-, Hydroxyl- oder Aminogruppe.

In den vorstehenden Formeln können mehrmals vorhandene Reste R, R', X bzw. Y bei einer Verbindung jeweils die gleiche oder unterschiedliche Bedeutung haben. Es können auch Mischungen verschiedener hydrolysierbarer Silane verwendet werden.

Anstelle der hydrolysierbaren Silane oder (dies ist bevorzugt) in Mischung mit den hydrolysierbaren Silanen können erfindungsgemäß auch hydrolysierbare Metallverbindungen eingesetzt werden, vorzugsweise solche, die sich von Metallen der Hauptgruppen Ia, IIa, IIIa und IVa sowie den Nebengruppen IVb, Vb und Vlb des Periodensystems ableiten, wobei Verbindungen von Aluminium, Titan und Zirkonium (z.B. die Alkoxide von Al, Ti und/oder Zr) besonders bevorzugt sind.

Beispiele für anorganische Bindemittel sind Silicon-Lacke, die z.B. aus hydrolysierbaren Silanen hergestellt werden, die keine nicht-hydrolysierbaren Substituenten aufweisen, also z.B. Verbindungen der obigen Formel RₙSiX₄₋ₙ, worin n = 0 und X wie vorstehend definiert ist. Anstelle oder neben diesen Silanen können auch Metallverbindungen eingesetzt werden, die sich vorzugsweise von Metallen der Hauptgruppen Ia, IIa, IIIa und IVa sowie den Nebengruppen IVb, Vb und VIb des Periodensystems ableiten, wobei Verbindungen von Aluminium, Titan und Zirkonium besonders bevorzugt sind.

Ein weiteres Beispiel für ein einsetzbares anorganisches Bindemittel sind nicht vollständig kristallisierte Fällungsprodukte der vorstehend genannten Indium- und Zinn-Verbindungen. Dabei werden die gleichen Verbindungen, Bedingungen und Verfahren eingesetzt, die für die Ausfällung der Indium-Zinn-Oxid-Vorstufen beschrieben sind, außer daß vorzugsweise keine oberflächenmodifizierende Komponente eingesetzt wird.

Dieses ITO-Fällungsprodukt wird gegebenenfalls getrocknet aber nicht calciniert, so daß es sich um ein nicht vollständig kristallisiertes Hydroxy(oxy)-Produkt handelt, das Oberflächen-Hydroxylgruppen aufweisen kann.

Die Bindemittel, insbesondere die anorganischen und organisch modifizierten, anorganischen Bindemittel, können auch in Form ihrer Monomere oder Vorkondensate eingesetzt werden und nach Mischung mit dem erfindungsgemäßen ITO-Pulver oder der erfindungsgemäßen ITO-Suspension weiter kondensiert werden.

Die Bindemittel können auch nanoskalige anorganische Feststoffteilchen (Nanopartikel) enthalten. Die einsetzbaren Nanopartikel haben beispielsweise eine mittlere Teilchengröße von nicht mehr als 200 nm, bevorzugt liegt der Teilchengrößenbereich unter 50 nm. Die Nanopartikel können z.B. in Form von Pulvern oder Solen zugegeben werden.

Die nanoskaligen anorganischen Feststoffteilchen können aus beliebigen Materialien bestehen, vorzugsweise bestehen sie jedoch aus Metallen und insbesondere aus Metallverbindungen wie beispielsweise (gegebenenfalls hydratisierten) Oxiden wie ZnO, CdO, SiO₂, TiO₂, ZrO₂ CeO₂, SnO₂, Al₂O₃, In₂O₃, La₂O₃, Fe₂O₃, Cu₂O, Ta₂O₅, Nb₂O₅, V₂O₅, MoO₃ oder WO₃; Chalkogeniden wie beispielsweise Sulfiden (z.B. CdS, ZnS, PbS und Ag₂S), Seleniden (z.B. GaSe, CdSe und ZnSe) und Telluriden (z.B. ZnTe oder CdTe), Halogeniden wie AgCl, AgBr, Agl, CuCl, CuBr, Cdl₂ und Pbl₂; Carbiden wie CdC₂ oder SiC; Arseniden wie AlAs, GaAs und GeAs; Antimoniden wie InSb; Nitriden wie BN, AIN, Si₃N₄ und Ti₃N₄; Phosphiden wie GaP, InP, Zn₃P₂ und Cd₃P₂; Phosphaten, Silikaten, Zirkonaten, Aluminaten, Stannaten und den entsprechenden Mischoxiden (z.B. solchen mit Perowskitstruktur wie BaTiO₃ und PbTiO₃).

Es können auch nanoskalige anorganische Feststoff-Teilchen eingesetzt werden, die mit polymerisierbaren und/oder polykondensierbaren organischen Oberflächengruppen versehen sind. Solche polymerisierbaren und/oder polykondensierbaren Nanopartikel und ihre Herstellung sind z.B. in der DE 197 46 885 beschrieben.

Beispiele für bevorzugte Bindemittel sind die in der DE-A-41 18 184 beschriebenen fluorhaltigen anorganischen Polykondensate und insbesondere die in der DE-A-43 38 361 beschriebenen epoxidgruppenhaltige Polyorganosiloxane.

Diese aus ITO-Suspension und Bindemittel erhaltene Mischung kann ebenfalls als Beschichtungsmasse und Formmasse für Beschichtungszwecke eingesetzt werden, wobei ITO-Schichten erhalten werden. Mit der Beschichtungszusammensetzung aus ITO-Pulver und Bindemittel können transparente, kratzfeste, IR-absorbierende Schichten auf allen (auch transparenten) Substraten hergestellt werden.

Bei der Zerkleinerung oder Dispergierung können gegebenenfalls auch zusätzlich ein oder mehrere Bindemittel zugesetzt werden. Diese können z.B. auch als Mischungen mit den eingesetzten Lösungsmitteln zugegeben werden. Beispiele für einsetzbare Bindemittel sind vorstehend beschrieben: Für die Ausführung der Zerkleinerungs- oder Dispergierungsbehandlung unter Zusatz eines oder mehrerer Bindemittel gilt das gleiche, was vorstehend für die Zugabe eines oder mehrerer Lösungsmittel beschrieben worden ist. Die Mengen des eingesetzten Bindemittels können so sein, daß die vorstehend beschriebenen Füllgrade erhalten werden. Es werden dann Mischungen erhalten, die beispielsweise als Beschichtungsmasse direkt für Beschichtungszwecke verwendet werden können. Prinzipiell kann das Bindemittel, sofern es eine geeignete Viskosität aufweist, auch anstelle des Lösungsmittels verwendet werden.

Aus der ITO-Suspension kann aber auch durch Entfernung der flüssigen Komponenten (z. B. durch Filtrieren, Verdampfen, Zentrifugieren und/oder Trocknen) ein ITO-Pulver erhalten werden. Das erhaltene ITO-Pulver ist meist im wesentlichen nanokristallin.

Das so erhaltene ITO-Pulver und die ITO-Suspension und ITO-Beschichtungs- und Formmassen enthalten nanoskalige kristalline Partikel von Indium-Zinn-Oxid, die überwiegend aus Primärpartikeln bestehen und praktisch nicht als Aggregate vorliegen. Durch das erfindungsgemäße Verfahren ist es somit möglich, Pulver, Suspensionen, Formkörper und Beschichtungs- und Formmassen auf der Basis von Indium-Zinn-Oxid bereitzustellen, bei denen die Partikelgröße nicht mehr als 200 nm beträgt. Insbesondere können Partikelgrößen von unter 50 bzw. unter 20 nm und sogar von etwa 10 bis 11 nm erhalten werden. Die Partikelgröße liegt meist über 2 nm, noch häufiger über 5 nm. Überraschenderweise können die so erhaltenen Pulver ohne weiteres z. B. in alkoholischen Lösungen (z.B. Ethanol), aber auch in Wasser, auf ihre vollständige Primärteilchengröße dispergiert werden, wobei die vorstehend genannte Partikelgröße erhalten bleibt, also die Primärpartikel ohne Aggregatbildung erhalten bleiben. Für die Dispergierung der ITO-Pulver können prinzpiell alle geeigneten Lösungsmittel verwendet werden, beispielsweise die vorstehend für die Fällung beschriebenen Lösungsmittel.

Es ist möglich, das Indium-Zinn-Oxid als Pulver aufzubewahren und bei Bedarf z.B. entweder als Pulver selbst, als Suspension, als Beschichtungs- oder Formmasse oder als Formkörper zu verwenden. Unter Beschichtungs- und Formmassen sind auch Pasten zu verstehen, die z.B. durch Umsetzung des ITO-Pulvers mit viskosen Lösungsmitteln erhalten werden. Die vorstehend genannten ITO-Materialien können vorzugsweise zur Beschichtung z.B. mittels Tauch- oder Sprühverfahren verwendet werden.

Aus dem ITO-Pulver lassen sich über die dem Fachmann bekannten Formgebungsverfahren Formkörper herstellen. Beispielsweise seien Extrusion, Schlickerguß, Spritzgießen, Elektrophorese, Foliengießen oder Siebdruck genannt. Es können dabei, je nach dem angewendeten Verfahren, auch Bindemittel eingesetzt werden. Als Bindemittel kommen z.B. die vorstehend genannten in Frage. Als Formkörper können z. B. Schichten oder Sinterkörper, insbesondere Targets hergestellt werden. Targets werden insbesondere beim Sputter-Verfahren zur Beschichtung von Substraten eingesetzt. Ein besonderer Vorteil der erfindungsgemäßen Materialien besteht darin, daß für die Formgebung der Formkörper gegenüber den üblichen Indium-Zinn-Oxid-Materialien wesentlich geringere Temperaturen benötigt werden. Die erfindungsgemäß hergestellten Formkörper finden als Bauteile oder Funktionskörper für leitfähige Systeme in der Opto- und Mikroelektronik oder als ITO-Quelle in Sputteranlagen Verwendung.

Die erfindungsgemäß hergestellten ITO-Materialien können wie gesagt für Beschichtungszwecke eingesetzt werden, wobei in dem ITO-Material ein oder mehrere Bindemittel enthalten sein können. Die zur Beschichtung geeigneten Verfahren sind die herkömmlichen und dem Fachmann bekannten. Beispiele hierfür sind Tauchen, Sprühen, Rakeln, Streichen, Bürsten und Schleudern. Zur Beschichtung eignen sich Substrate aus beliebigen Materialien, wie z:B. Kunststoff, Metall, Glas, Halbleiter (z.B. Siliciumwafer) oder Keramik. Die ITO-Schichten können zur IR-Blockierung und zur Antistatikausrüstung verwendet werden. Die IR-Blockierung kann z.B. durch IR-Absorption oder durch IR-Reflektion erfolgen.

Die erfindungsgemäß hergestellten ITO-Materialien finden bevorzugt als Beschichtungsmaterial in der Opto- und Mikroelektronik oder für optische (transparente), IR-blockierende oder leitfähige Beschichtungen Verwendung. Außerdem können sie für Siebdruckpasten verwendet werden. Sie können beispielsweise bevorzugt eingesetzt werden für transparente Ahsteuerelektroden für Flüssigkristalldisplays, Dünnfilmelektrolumineszenz-Displays, Elektrochromie-Displays, transparente leitfähige Schichten für hochempfindliche Strahlungsselektoren, ferroelektrische Photoleiter, Speicheranordnungen, transparente leitfähige Oxidfilme als Gateelektroden für Ladungs-, Injektions- und ladungsgekoppelte Anordnungen, sowie zur Herstellung von Druckpasten, die sich für die Bedruckung von Glas, Keramik und Kunststoffen eignen, zur Abschirmung von elektromagnetischen Wellen, für IR-reflektierenden Schichten bzw. Kunststoffe, leitfähige Elektroden für Solarzellen oder antistatische Filme, z.B. für Fernsehröhren, Monitore und Kontaktbildschirme.

Weitere Einsatzmöglichkeiten für die erfindungsgemäßen ITO-Materialien ist die Verwendung für Plastikverscheibungen, IR-Sperren für Projektoren, IR-Sperren nach Lampen, IR-absorbierende Anstriche und Lacke, Wärmeschutzscheiben (z.B. als Beschichtung von Glasscheiben für Backöfen), Sonnenkollektoren, Schichten auf Wärmetauschern, sowie transparente Wärmestrahlenabsorber auf Metallen, Glas, Keramiken und Kunststoffen, wie Anti(be)taubeschichtungen auf allen Substraten und Gegenständen (z.B. Fahrzeuge, Fenster, Fassaden, Instrumente, Verkehrsschilder, Hinweisschilder und Fenster von Kühlanlagen).

Die folgenden Beispiele erläutern die Erfindung, ohne sie zu beschränken.

### Beispiele

### 1. Herstellung einer ITO-Suspension bzw. eines ITO-Pulvers

### a) Herstellung der Vorstufe InO (OH)

- 140 g Indium(+III)chlorid (0,63 mol wasserfrei)
- 18 g Zinn(+IV)chlorid x 5 H₂O
- 5,6 g Caprolactam
werden in 1400 ml Wasser gegeben und gerührt. Nachdem eine klare Lösung entstanden ist, wird diese auf 50°C erwärmt. Nachdem die Temperatur erreicht ist, tropft man unter heftigem Rühren 105 ml Ammoniumhydroxidlösung (25%ig) zu. Die Suspension wird bei einer Temperatur von 50°C weitere 24 Stunden gerührt. Zur vollständigen Fällung werden dem Gemisch danach noch 280 ml Ammoniumhydroxidlösung hinzugefügt. Es bildet sich ein weißer Niederschlag aus Indiumoxidhydroxid, der abzentrifugiert wird (30 min bei 4000 U/min). Das Pulver wird im Vakuumtrockenschrank bei 190°C so lange getrocknet, bis eine leichte Gelbfärbung des Pulvers festzustellen ist (Übergang zu kristallinem Indiumoxid).

### b) Nachbehandlung des getrockneten Indiumoxidhydroxids

Das getrocknete Pulver wird fein gemörsert, in Kristallisierschalen verteilt und in einen Formiergas-Ofen gestellt. Der Ofen wird evakuiert, dann mit Stickstoff geflutet. Der Ofen wird mit einer Heizrate von 250°C/Stunde auf 250°C aufgeheizt bei einem Stickstoffluß von 200 Liter/Stunde. Diese Temperatur wird für 60 Minuten unter Formiergasatmosphäre bei einem Gasfluß von 300 Liter/Stunde gehalten. Danach kühlt der Ofen unter Stickstoffatmosphäre bis auf Raumtemperatur ab (Dauer: ca. 5 Stunden). Hieraus resultiert ein dunkelblaues Pulver, das mittels Röntgenanalyse als reine Indiumoxidphase identifizierbar war.

### c) Aufarbeitung des Indiumoxidpulvers

### Variante 1

In einer Mörsermühle legt man 25 g eines Gemisches aus 50 Gew.-% Ethylenglycol, 50 Gew.-% Diethylenglycolmonobutylether (alternativ können Diethylenglycol für Ethylenglycol und/oder Dibutylenglycolether für Diethylenglycolmonobutylether verwendet werden) sowie 5,6 g 3,6,9-Trioxadecansäure vor. 75 g erfindungsgemäß hergestelltes ITO-Pulver werden langsam hinzugefügt und es wird 1 bzw. 2 Stunden gemahlen. Danach ergibt sich eine dunkelblaue hochviskose Suspension, die für ca. 20 Minuten in einem Walzenstuhl homogenisiert wird. Die so erhaltene Suspension wird in Ethanol redispergiert, indem 43 g der so erhaltenen Suspension in 57 g Ethanol gegeben und gerührt werden.

Durch Abtrennen des Ethanols erhält man ITO-Pulver, die sich in Ethanol auf eine Teilchengröße unter 20 nm redispergieren lassen. Die Primärteilchengröße liegt bei 10 bis 11 nm, die spezifische Oberfläche bei 70 m²/g. Isoelektrischer Punkt: 7,2. Der Gehalt an Zinn liegt üblicherweise bei 8 mol-%. Aus diesen Pulvern lassen sich Sol-Gel-Schichten applizieren, die bei einer Filmdicke von 400 nm bei einer Einbrenntemperatur von 550°C auf Glas eine Transmission > 90 % und einen Flächenwiderstand von 160 Ω/□ realisieren können. Der Auftrag mehrerer Schichten ist möglich, wobei der Flächenwiderstand weiter abgesenkt wird. So liegt der erzielte Flächenwiderstand bei einem Zweischichter (600 nm Schichtdicke) bereits bei 100 Ω/□.

### Variante 2

In einer Mörsermühle legt man 25 g Ethanol (oder Butanol) und 5,6 g 3,6,9-Trioxadecansäure vor. 75 g erfindungsgemäß hergestelltes ITO-Pulver werden langsam hinzugefügt und es wird 2 h gemahlen. Danach ergibt sich eine dunkelblaue hochviskose Suspension, die für ca. 20 Minuten in einem Walzenstuhl homogenisiert wird. Die so erhaltenen ITO Suspension wird mit 144,4 g Ethanol verdünnt und gerührt.

Nach beiden Varianten wird eine ITO-Suspension mit 30 Gew.-% ITO bzw. 5,4 Vol-% Nanopartikeln in Ethanol erhalten. Die Suspension wird für Beschichtungszwecke verwendet (s. oben).

### Variante 3

In einen Walzenkneter werden 30 g Ethanol (oder Butanol oder ein Gemisch Ethylenglycol/Diethylenglycolmonobutylether 50/50) sowie 7,2 g 3,6,9-Trioxadecansäure vorgelegt. Unter Kneten werden 5 x 20 g ITO-Pulver zugegeben und 30 Minuten homogenisiert. Man erhält eine hochviskose dunkelblaue Flüssigsuspension mit einem Feststoffgehalt von bis zu 80 Gew.-% (entspricht 38 Vol.-%). Diese wird in Ethanol dispergiert, indem 40 g der so erhaltenen Suspension in 70 g Ethanol gegeben und gerührt werden (Feststoffgehalt 4,6 Vol.-%).

### 2. Herstellung eines Targets aus erfindungsgemäßem ITO Material

Targets als ITO-Quelle in Sputteranlagen werden in diesem Beispiel durch elektrophoretische Abscheidung hergestellt. Die hierfür verwendete Abscheidezelle besteht aus zwei gegenüberliegenden kreisförmigen, ebenen polierten Elektroden mit einem nutzbaren Durchmesser von 25 mm zwischen denen sich die Suspension befindet. Die Abscheideelektrode besteht aus glasartigem Kohlenstoff und die Gegenelektrode aus nichtrostendem Edelstahl.

Systematische elektrophoretische Abscheideversuche aus der ethanolischen ITO-Suspension (nach obiger Variante 1 hergestellt) mit einem Feststoffgehalt von 30 Gew.% bzw. 5,4 Vol% wurden in Abhängigkeit von der Abscheidedauer (15-60 min) sowie der Abscheidefeldstärke (30-180. V/cm) durchgeführt. Die auf der Abscheideelektrode abgeschiedene Masse der Grünkörper wächst linear mit der angelegten Feldstärke bzw. der Abscheidedauer an. Die auf die Feldstärke (V/cm) und auf die Abscheidedauer (min) normierte abgeschiedene Masse beträgt ca. 3·10⁻³ g·cm/ min-V. Dies entspricht einer normierten Scherbenbildungsgeschwindigkeit (cm/min) von ca. 2,4·10⁻⁴ cm·cm/min·V. So wird bei einer Abscheidefeldstärke von 30 V/cm und einer Abscheidedauer von 60 min ein Grünkörper mit einer Dicke von 4,3 mm abgeschieden. Nach der Abscheidung und dem Trennen des ITO-Grünkörpers von der Abscheideelektrode wurden kompakte Grünkörper erhalten, die sich rißfrei trocknen lassen. Die getrockneten ITO-Grünkörper weisen Gründichten von 40 % der theoretischen Dichte auf.

Sinterversuche in atmosphärischen Öfen mit gekapselten ITO-Formkörpem (Grünkörpern; Al₂O₃-Kapsel) wurden im Temperaturintervall von 1400 - 1600°C drucklos durchgeführt Mit steigender Sintertemperatur wird eine zunehmende thermische Verdichtung erhalten. Nach einer Sinterdauer von 6 h bei 1600°C wird eine Dichte von 97% der theoretischen Dichte erreicht.

### 3. Herstellung einer Beschichtungsmasse aus erfindungsgemäßem ITO-Material

a) Herstellung eines Böhmitsols (nach DE-A-4338361):
   0,48 g Essigsäure-stabilisiertes (6,4 Gew.% Essigsäure) Böhmitpulver wurden mit 34,06 g 0,1n HCl versetzt. Es entstand eine transparente farblose Suspension, die direkt zur Herstellung des Sols A weiterverwendet wurde.
b) Herstellung eines Sols A (nach DE-A-4338361):
   Eine Mischung von 23,63 g Glycidylpropyltrimethoxysilan (GPTS) und 12,50 g Tetraethoxysitan (TEOS) wurde mit 4,86 g des obigen Böhmitsols versetzt. Die Reaktionsmischung wurde 2 Stunden bei Raumtemperatur gerührt und anschliessend unter Eiskühlung mit 11,36 g Aluminiumtributoxyethanolat versetzt. Nach beendeter Zugabe wird das Gemisch weitere 2 h bei 0 °C gerührt und anschliessend portionsweise mit 29,68 g des obigen Böhmitsols versetzt.
c) Einarbeitung der ITO-Nanopartikel:
   Eine 40 Gew.%ige (= 6,9 Vol%) Suspension der erfindungsgemäß hergestellten ITO-Nanoparükel (Variante 1) in Wasser (alternativ kann z.B. Ethanol oder Butanol verwendet werden) wird mit dem Sol A gemischt und 12 h bei 25 °C gerührt. Die eingesetzten Mengen an Suspension und Sol A richten sich nach dem gewünschten ITO-Füllgrad (= Vol.-% ITO bzgl. Gesamtfeststoffgehalt) der Schichten.
   Mit 28,69 g 40 Gew%-iger bzw. 6,9 Vol%-iger ITO-Suspension und 10,00 g Sol A wird z.B. eine Beschichtung mit einem Füllgrad an ITO von 80 Gew% bzw. 68 Vol% erhalten.
d) Verarbeitung zu Schichten:
   Mit der Beschichtungsmasse wird Polycarbonat, Glas und Kieselglas über Spin-Coating (Schleudern) beschichtet. Die Substrate wurden vorher mit einem Ar/O₂-Plasma behandelt, aber die Behandlung ist nicht essentiell für die unten beschriebenen Eigenschaften. Die beschichteten Substrate werden entsprechend der Vorschrift für das Bindemittel 2-4 h bei 120-140°C gehärtet.

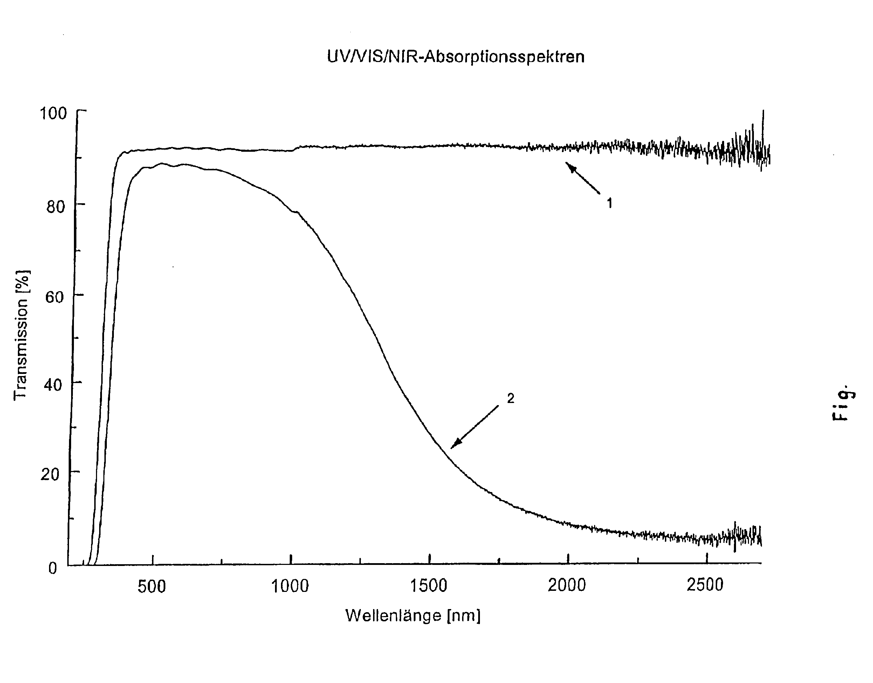

Die Figur zeigt Absorptionsspektren von Glas mit ITO-freier Schicht (Kurve 1) sowie Glas mit ITO-haltiger Schicht (80 Gew.% bzw. 68 Vol% ITO Füllgrad) (Kurve 2) bei 200 bis 2700 nm. Man sieht, daß beide Schichten im sichtbaren Bereich transparent und farblos sind und die ITO-haltige Schicht im NIR Bereich absorbiert.

## Patentansprüche

1. Verfahren zur Herstellung von Suspensionen und Pulvern auf Basis von Indium-Zinn-Oxid, **dadurch gekennzeichnet, daß** man
a) Indium-Zinn-Oxid-Vorstufen aus Lösungen von Indium- und Zinn-Verbindungen in einem oder mehreren Lösungsmitteln in Gegenwart einer oder mehrerer oberflächenmodifizierender Komponenten ausfällt,
b) das erhaltene Pulver nach Entfernung des Lösungsmittels calciniert,
c) nach dem Calcinieren eine oder mehrere oberflächenmodifizierende Komponenten und ein oder mehrere Lösungsmittel zugibt,
d) die erhaltene Mischung einer Zerkleinerungs- oder Dispergierbehandlung unter Bildung einer Suspension unterwirft und
e) gegebenenfalls flüssige Komponenten aus der Suspension abtrennt, um ein Pulver zu erhalten, **dadurch gekennzeichnet dass** als oberflächenmodifizierende Komponente bei der Zerkleinerung oder Dispergierung Mono- oder Polycarbonsäuren, Diketone, Aminosäuren, Polyethylenoxydderivate, Amine oder Säureamide oder Mischungen aus zwei oder mehreren dieser Komponenten eingesekt werden.

2. Verfahren nach Anspruch 1, **dadurch gekennzeichnet, daß** als Indium- und Zinn-Verbindungen Indium(+III)chlorid, indium(+III)iodid, Indium(+I)chlorid, Indium(+I)iodid, Indium(+III)nitrat, Indium(+III)acetat, Indium(+III)sulfat und/oder Indium(+III)alkoxide bzw. Zinnchlorid, Zinnsulfat und/oder Zinnalkoxide eingesetzt werden, wobei Zinn in der Oxidationsstufe +2 oder +4 vorliegt.

3. Verfahren nach Anspruch 1 oder 2, **dadurch gekennzeichnet, daß** als oberflächenmodifizierende Komponente bei der Fällung Mono- oder Polycarbonsäuren, Diketone, Aminosäuren, Polyethylenoxidderivate, Amine oder Säureamide oder Mischungen aus zwei oder mehreren dieser Komponenten eingesetzt werden.

4. Verfahren nach einem der Ansprüche 1 bis 3, **dadurch gekennzeichnet, daß** 3,6,9-Trioxadecansäure, β-Alanin, Sorbitanmonooleatpolyoxyalkylen und/oder Caprolactam als oberflächenmodifizierende Komponente eingesetzt werden.

5. Verfahren nach einem der Ansprüche 1 bis 4, **dadurch gekennzeichnet, daß** zur Fällung der Indium-Zinn-Oxid-Vorstufe eine Base eingesetzt wird.

6. Verfahren nach einem der Ansprüche 1 bis 5, **dadurch gekennzeichnet, daß** die Calcinierung bei 200 bis 400°C durchgeführt wird.

7. Verfahren nach einem der Ansprüche 1 bis 6, **dadurch gekennzeichnet, daß** unter reduzierenden Bedingungen calciniert wird oder daß nach der Calcinierung reduziert wird.

8. Verfahren nach einem der Ansprüche 1 bis 7, **dadurch gekennzeichnet, daß** die Zerkleinerung in einem hochsiedenden Lösungsmittel, insbesondere Diethylenglycol oder Diethylenglycolmonobutylether, durchgeführt wird.

9. Verfahren nach einem der Ansprüche 1 bis 8, **dadurch gekennzeichnet, daß** die Suspension oder das Pulver zu Formkörpern verarbeitet wird.

10. Suspensionen, Pulver und ungesinterte Formkörper auf der Basis von Indium-Zinn-Oxid, in denen Indium-Zinn-Oxid-Partikel enthalten sind, die auf der Oberfläche mit oberflächenmodifizierenden Komponenten ausgewählt aus Mono- oder Polycarbonsäuren, Diketonen, Aminosäuren, Polyethylenoxidderivaten, Aminen und/oder Säureamiden oberflächenmodifiziert sind, erhältlich nach dem Verfahren gemäß einem der Ansprüche 1 bis 9.

11. Beschichtungs- oder Formmasse, enthaltend eine Suspension oder ein Pulver gemäß Anspruch 10 und gegebenenfalls ein oder mehrere Bindemittel.

12. Verwendung der Indium-Zinn-Oxid-Masse nach Anspruch 11 als Beschichtungsmaterial, insbesondere für mikro- und optoelektronische Zwecke.

13. Verwendung der Indium-Zinn-Oxid-Masse nach Anspruch 11 für Siebdruckpasten oder zur Antistatik-Ausrüstung.

14. Verwendung der Indium-Zinn-Oxid-Masse nach Anspruch 11 zur Herstellung von Formkörpern, insbesondere Targets für Sputter-Anlagen.

## Claims

1. Method of preparing suspensions and powders based on indium tin oxide, **characterized in that**
a) indium tin oxide precursors are precipitated from solutions of indium compounds and tin compounds in one or more solvents in the presence of one or more surface-modifying components,
b) the resulting powder is calcined after removing the solvent,
c) after calcining one or more surface-modifying components and one or more solvents are added,
d) the resulting mixture is subjected to a comminuting or dispersing treatment, with formation of a suspension, and
e) optionally, liquid components are separated from the suspension to give a powder,
**characterized in that** monocarboxylic or polycarboxylic acids, diketones, amino acids, polyethylene oxide derivatives, amines or acid amides or mixtures of two or more of these components are used as surface-modifying components during comminution or dispersion.

2. Method according to Claim 1, **characterized in that** indium compounds and tin compounds used comprise indium(+III) chloride, indium(+III) iodide, indium(+I) chloride, indium(+I) iodide, indium(+III) nitrate, indium(+III) acetate, indium(+III) sulphate and/or indium(+III) alkoxides and, respectively, tin chloride, tin sulphate and/or tin alkoxides, tin being present in an oxidation state of +2 or +4.

3. Method according to Claim 1 or 2, **characterized in that** monocarboxylic or polycarboxylic acids, diketones, amino acids, polyethylene oxide derivatives, amines or acid amides or mixtures of two or more of these components are used as surface-modifying components during precipitation.

4. Method according to any one of Claims 1 to 3, **characterized in that** 3,6,9-trioxadecanoic add, β-alanine, sorbitan monooleate polyoxyalkylene and/or caprolactam are used as surface-modifying component.

5. Method according to any of Claims 1 to 4, **characterized in that** a base is used to precipitate the indium tin oxide precursor.

6. Method according to any of Claims 1 to 5, **characterized in that** calcining is conducted at from 200 to 400°C.

7. Method according to any of Claims 1 to 6, **characterized in that** calcining is conducted under reducing conditions or **in that** reduction is carried out after calcining.

8. Method according to any of Claims 1 to 7, **characterized in that** the comminution is conducted in a high-boiling solvent, especially diethylene glycol or diethylene glycol monobutyl ether.

9. Method according to any of Claims 1 to 8, **characterized in that** the suspension or the powder is processed into mouldings.

10. Suspensions, powders and non-sintered mouldings based on indium tin oxide, comprising indium tin oxide particles the surface of which has been surface-modified with surface-modifying components selected from monocarboxylic or polycarboxylic acids, diketones, amino acids, polyethylene oxide derivatives, amines and/or acid amides, obtainable by the method according to any of Claims 1 to 9.

11. Coating composition or moulding composition, comprising a suspension or a powder according to Claim 10 and, if desired, one or more binders.

12. Use of the indium tin oxide composition according to Claim 11 as coating material, especially for microelectronics and optoelectronics purposes.

13. Use of the indium tin oxide composition according to Claim 11 for screen printing pastes or for antistatic treatment.

14. Use of the indium tin oxide composition according to Claim 11 to produce mouldings, especially targets for sputtering installations.

## Revendications

1. Procédé de préparation de suspensions et de poudres à base d'oxyde d'indium-étain, **caractérisé en ce que** :
a) on fait précipiter des précurseurs d'oxyde d'indium-étain, à partir de solutions de composés de l'indium et de l'étain dans un ou plusieurs solvants, en présence d'un ou de plusieurs composants modificateurs de surface,
b) on calcine la poudre obtenue, après en avoir chassé le solvant,
c) on y ajoute, après cette calcination, un ou plusieurs composants modificateurs de surface et un ou plusieurs solvants,
d) on soumet le mélange ainsi obtenu à une opération de broyage ou de dispersion, avec formation d'une suspension,
e) et l'on sépare éventuellement de la suspension les composants liquides, pour obtenir une poudre,
et **caractérisé en ce qu'**on utilise en tant que composants modificateurs de surface, lors de l'opération de broyage ou de dispersion, des acides monocarboxyliques ou polycarboxyliques, des dicétones, des acides aminés, des dérivés polyéthoxylés, des amines ou des amides d'acide, ou des mélanges de deux de ces composés ou plus.

2. Procédé conforme à la revendication 1, **caractérisé en ce que** l'on emploie, en tant que composés de l'indium et de l'étain, du chlorure d'indium(+III), de l'iodure d'indium(+III), du chlorure d'indium(+I), de l'iodure d'indium(+I), du nitrate d'indium(+III), de l'acétate d'indium(+III), du sulfate d'indium(+III) et/ou un alcoxyde d'indium(+III), et du chlorure d'étain, du sulfate d'étain et/ou un alcoxyde d'étain où l'étain se trouve à l'état d'oxydation +II ou +IV.

3. Procédé conforme à la revendication 1 ou 2, **caractérisé en ce que** l'on utilise en tant que composants modificateurs de surface, lors de la précipitation, des acides monocarboxyliques ou polycarboxyliques, des dicétones, des acides aminés, des dérivés polyéthoxylés, des amines ou des amides d'acide, ou des mélanges de deux de ces composés ou plus.

4. Procédé conforme à l'une des revendications 1 à 3, **caractérisé en ce que** l'on emploie, en tant que composants modificateurs de surface, de l'acide 3,6,9-trioxa-décanoïque, de la β-alanine, un monooléate de sorbitanne polyalcoxylé et/ou du caprolactame.

5. Procédé conforme à l'une des revendications 1 à 4, **caractérisé en ce que** l'on utilise une base pour faire précipiter les précurseurs d'oxyde d'indium-étain.

6. Procédé conforme à l'une des revendications 1 à 5, **caractérisé en ce que** l'on opère la calcination à une température de 200 à 400 °C.

7. Procédé conforme à l'une des revendications 1 à 6, **caractérisé en ce que** l'on opère la calcination dans des conditions réductrices, ou bien l'on opère une réduction après la calcination.

8. Procédé conforme à l'une des revendications 1 à 7, **caractérisé en ce que** l'on effectue le broyage dans un solvant à haut point d'ébullition, en particulier dans du diéthylèneglycol ou de l'éther monobutylique de diéthylèneglycol.

9. Procédé conforme à l'une des revendications 1 à 8, **caractérisé en ce que** l'on met la suspension ou la poudre sous forme de corps façonnés.

10. Suspensions, poudres et corps façonnés non frittés, à base d'oxyde d'indium-étain, dans lesquels sont contenues des particules d'oxyde d'indium-étain qui sont modifiées en surface par des composants modificateurs de surface choisis parmi des acides monocarboxyliques ou polycarboxyliques, des dicétones, des acides aminés, des dérivés polyéthoxylés, des amines ou des amides d'acide, ou des mélanges de deux de ces composés ou plus, et que l'on peut obtenir par un procédé conforme à l'une des revendications 1 à 9.

11. Masse à façonner ou à étaler en revêtement, contenant une suspension ou une poudre, conforme à la revendication 10, et en option, un ou plusieurs liants.

12. Emploi d'une masse à l'oxyde d'indium-étain, conforme à la revendication 11, en tant que matériau de revêtement, en particulier pour des applications en microélectronique ou en optoélectronique.

13. Emploi de masses à l'oxyde d'indium-étain, conformes à la revendication 11, pour en faire des pâtes de sérigraphie ou des apprêts antistatiques.

14. Emploi de masses à l'oxyde d'indium-étain, conformes à la revendication 11, pour la fabrication de corps façonnés, en particulier de cibles pour dispositifs de pulvérisation.
